# EUROPÄISCHE PATENTSCHRIFT

(11) **EP 3 175 465 B1**
(45) Veröffentlichungstag und Bekanntmachung des Hinweises auf die Patenterteilung: **23.05.2018**
(21) Anmeldenummer: 15766435.0
(22) Anmeldetag: 15.09.2015
(51) Int. Cl.: H01F 41/02, H01F 41/22, C23C 16/56, B22F 3/10, C23C 16/06

(54) **VERFAHREN ZUR HERSTELLUNG EINES PERMANENTMAGNETEN**
METHOD FOR MANUFACTURING A PERMANENT MAGNET
PROCÉDÉ DE FABRICATION D'UN AIMANT PERMANENT

(30) Priorität: 25.09.2014 DE 102014219378
(43) Veröffentlichungstag der Anmeldung: 07.06.2017
(73) Patentinhaber: Siemens Aktiengesellschaft, 80333 München (DE)
(72) Erfinder: BUSCHBECK, Jörg, 90482 Nürnberg (DE); DEIM, Sybille, 90475 Nürnberg (DE); SCHARRER, Martin, 91220 Schnaittach (DE)
(86) Internationale Anmeldenummer: PCT/EP2015/071071
(87) Internationale Veröffentlichungsnummer: WO 2016/046022

(56) Entgegenhaltungen:
- EP-A1- 1 879 201
- JP-A- 2011 101 043
- JP-A- 2012 212 830
- US-A1- 2007 034 299

## Beschreibung

Die Erfindung betrifft ein Verfahren zur Herstellung eines Permanentmagneten, bei dem ein magnetischer Körper mittels Sintern aus einem metallhaltigen Pulver gebildet wird.

Aus dem Stand der Technik ist es bekannt, Permanentmagnete, die aus einer Neodym, Eisen und Bor enthaltenden Legierung hergestellt sind, in einer Vielzahl von elektrodynamischen Anwendungen vorzusehen. So sind beispielsweise derartige Permanentmagnete aufweisende elektrodynamische Maschinen bekannt, die insbesondere als Synchronmotoren oder als Generatoren, insbesondere für Windkraftanlagen, ausgebildet sind.

Bei der Herstellung von solchen Permanentmagneten ist es allgemein bekannt, schwere Seltenerdelemente, insbesondere Terbium und/oder Dysprosium zuzusetzen, um eine ausreichende Koerzitivfeldstärke und Temperaturbeständigkeit sicherzustellen.

Gemäß einem bekannten Herstellungsverfahren werden Permanentmagnete durch Sintern eines metallhaltigen Pulvers in Gegenwart eines externen Feldes und unter Ausübung von Druck hergestellt. Gegebenenfalls können auch Presslinge verwendet werden, welche aus metallischem Pulver bestehen, das schon vor dem Sintern durch Pressen verfestigt wurde.

Ferner ist bekannt, den mittels Sintern gebildeten magnetischen Körper anschließend aus einem Sinterofen zu entnehmen, um ihn in eine Dysprosium oder Terbium enthaltende Lösung zu tauchen oder mit einer Dysprosium oder Terbium enthaltenden Paste zu bedrucken. Der so beschichtete magnetische Körper wird anschließend einer eine Diffusion des Seltenerdelements unterstützenden Wärmebehandlung unterzogen.

Zum Aufbringen derartiger seltenerdelementhaltiger Schichten schlägt US 2007/0034299 A1 unter anderem die chemische Gasphasenabscheidung vor. US 2009/0020193 A1 beschreibt ein Verfahren zur Herstellung eines Permanentmagneten, bei dem Schichten bestehend aus einer Legierung eines schweren Seltenerdelements und einem Metall aufgebracht werden. Hierzu muss eine Oxidschicht vor dem Aufbringen der Schicht von dem gesinterten Rolling mittels eines Sputterverfahrens abgetragen werden.

Aus DE 10 2013 205 437 A1 ist ferner ein Verfahren zum Beschichten eines Metallpulvers mittels chemischer Gasphasenabscheidung zum Herstellen von Permanentmagneten bekannt.

Aufgrund der begrenzten Verfügbarkeit und hohen Rohstoffkosten von Seltenerdelementen ist es wünschenswert, den Einsatz derartiger Materialien bei der Herstellung von Permanentmagneten zu minimieren.

Es ist somit Aufgabe der vorliegenden Erfindung, ein verbessertes Verfahren zur Herstellung von Permanentmagneten anzugeben, welches eine effiziente Nutzung der eingesetzten Menge von Seltenerdelementen ermöglicht.

Die Aufgabe wird gelöst durch ein Verfahren der eingangs genannten Art mit den kennzeichnenden Merkmalen des Patentanspruchs 1.

Vorteilhafte Ausgestaltungen sind Gegenstand der Unteransprüche.

Bei einem Verfahren zur Herstellung eines Permanentmagneten wird ein magnetischer Körper mittels Sintern aus einem metallhaltigen Pulver gebildet. Erfindungsgemäß ist vorgesehen, dass eine ein Seltenerdelement umfassende Komponente auf einer Oberfläche des magnetischen Körpers mittels chemischer Gasphasenabscheidung abgeschieden wird. Der so beschichtete magnetische Körper wird anschließend einer eine Diffusion der auf der Oberfläche des magnetischen Körpers abgeschiedenen Komponente entlang von Korngrenzen unterstützenden thermischen Behandlung unterzogen.

Mittels der chemischen Gasphasenabscheidung ist es möglich, eine selektive Beschichtung der Oberfläche des gesinterten magnetischen Körpers vorzunehmen. Im Gegensatz dazu erfordert ein physikalischer Aufdampfvorgang das Aufheizen des gesamten Sinterofens, was zur Folge hat, dass dann Seltenerdelemente überall im Sinterofen und nicht nur auf der zu beschichtenden Oberfläche des magnetischen Körpers abgeschieden werden. Die bei der chemischen Gasphasenabscheidung induzierte Oberflächenreaktion des die abzuscheidende Komponente führenden Gases bzw. Metalldampfes bewirkt somit eine im Wesentlichen auf die Oberfläche des magnetischen Körpers beschränkte Abscheidung, so dass die eingesetzte Menge von Seltenerdelementen optimal genutzt wird.

Die Prozessparameter der thermischen Behandlung sind derart gewählt, dass bei der Diffusion ein Diffusionsweg entlang von im gesinterten Material des magnetischen Körpers vorhandenen Korngrenzen bevorzugt wird. Bei einer chemischen Gasphasenabscheidung ohne Aktivierung erfolgt eine derartige Diffusion vorzugsweise im Temperaturbereich zwischen 800°C und 1000°C, bei einer Plasma aktivierten chemischen Gasphasenabscheidung liegt dieser Temperaturbereich zwischen 300°C und 700°C. Zur thermischen Wärmebehandlung für die Unterstützung der Korngrenzendiffusion sind Temperaturen zwischen 800°C und 1000°C, besonders bevorzugt 900°C vorgesehen. Die Seltenerdelemente lagern sich dementsprechend im Korngrenzen nahen Oberflächenbereich von im Material befindlichen Kristalliten an. Im Vergleich zu einer gleichmäßigen Verteilung von Seltenerdelementen - die auch als Seltenerdmetalle oder Seltenerden bezeichnet werden - muss eine kleinere Menge eingesetzt werden, um eine gewünschte Koerzitivfeldstärke zu erzeugen. Gleichzeitig erhält man höhere Werte der magnetischen Remanenz bei gleichem Materialeinsatz. Mit dem entlang von Korngrenzen stattfindenden Diffusionsprozess wird somit eine Einsparung der benötigten Menge von Seltenerdelementen realisiert und damit eine besonders kosteneffiziente Herstellung von Permanentmagneten ermöglicht.

Das metallische Pulver wird vorzugsweise durch Pressen bzw. Ausübung von Druck schon vor dem Sintern zumindest teilverfestigt. Die Erfindung betrifft somit gleichermaßen Verfahren, bei denen Presslinge gesintert werden, welche aus vorverfestigtem Pulver bestehen, als auch Verfahren, bei denen nicht verfestigtes metallisches Pulver zur Herstellung von Permanentmagneten direkt gesintert wird.

Darüber hinaus lässt sich die chemische Gasphasenabscheidung in besonders effizienter Art und Weise in den im Wesentlichen im Sinterofen stattfindenden Produktionsprozess integrieren. Im Gegensatz zu Verfahren, die zur Beschichtung des magnetischen Körpers ein Eintauchen in eine Seltenerdelement enthaltende Lösung oder ein Bedrucken mit einer Seltenerdelement enthaltende Paste erfordert, kann die Beschichtung mittels chemischer Gasphasenabscheidung ohne eine Entnahme des magnetischen Körpers aus dem Sinterofen erfolgen. Dies ist insbesondere deshalb vorteilhaft, da der Sinterprozess im Sinterofen typischer Weise unter Vakuum oder einer Schutzatmosphäre, insbesondere unter einer Edelgasatmosphäre oder unter einer Stickstoffatmosphäre, erfolgt. Durch eine Entnahme der magnetischen Körper aus dem Sinterofen kommt es zu einem Kontakt mit Sauerstoff, was eine Oxidation der Oberfläche bewirkt. Die auf dem magnetischen Körper gebildete Oxidschicht wirkt der Diffusion der Seltenerdelementen bei der anschließenden thermischen Behandlung entgegen, so dass die Oberflächen bei Verfahren, die auf einem Eintauchen oder einem Bedrucken der Oberfläche beruhen, vor der Beschichtung mechanisch nachbehandelt bzw. abgeschliffen werden müssen.

Eine derartige mechanische Behandlung der Oberfläche kann jedoch entfallen, wenn das das Seltenerdelement enthaltende Gas direkt in den Sinterofen zur chemischen Gasphasenabscheidung eingeleitet wird. Im Sinne dieser Spezifikation gilt auch ein das Seltenerdelement enthaltender Metalldampf als Gas, so dass diese Begriffe im Folgenden synonym verwendet werden. Gemäß der vorliegenden Erfindung erfolgen somit die das Sintern, die chemische Gasphasenabscheidung und die Diffusion unterstützende thermische Behandlung betreffenden Verfahrensschritte in dem gleichen Sinterofen.

Das Seltenerdelement ist vorzugsweise ein die Koerzitivfeldstärke erhöhendes schweres Seltenerdelement. In Weiterbildung der Erfindung ist vorgesehen, weitere Elemente zuzusetzen, um über eine Schmelzpunkterniedrigung den Diffusionsweg zu verlängern. Besonders bevorzugt wird eine derartige Erniedrigung des Schmelzpunkts mittels Zugabe von Nickel und/oder Aluminium bewirkt. In vorteilhafter Weise können bei der chemischen Gasphasenabscheidung unterschiedliche schwere Seltenerdelemente auf den Oberflächen der magnetischen Körper abgeschieden werden. Gemäß alternativen Ausführungsbeispielen erfolgt eine derartige Abscheidung in dem gleichen oder in aufeinander folgenden Verfahrensschritten.

Besonders bevorzugt ist das Seltenerdelement Dysprosium und/oder Terbium. Terbium ist im Allgemeinen für Anwendungen, die eine starke Erhöhung der Koerzitivfeldstärke erfordern, bevorzugt. In alternativen Ausführungsbeispielen ist vorgesehen, Mischungen aus Terbium und Dysprosium aufzubringen, wobei aus Terbium und Dysprosium bestehende Schichten entweder sequentiell in aufeinander folgenden Verfahrensschritten oder gleichzeitig aufgebracht werden, wofür entsprechende Mischungen aus Seltenerdelement enthaltende Gase zugeführt werden. Besonders bevorzugt wird die das zumindest eine Seltenerdelement umfassende Komponente insbesondere schichtweise auf der Oberfläche des magnetischen Körpers während eines dem Sintern unmittelbar anschließenden Abkühlvorgangs des magnetischen Körpers abgeschieden. Bei einem derartigen Vorgehen wird die zum Sintern erforderliche Wärmeenergie optimal genutzt, da die chemische Gasphasenabscheidung auf der vom Sintervorgang noch erhitzten Oberfläche des magnetischen Körpers erfolgt. Es ergeben sich somit Energieeinsparungen, welche durch den Wegfall des anderweitig zur Induktion der chemischen Gasphasenabscheidung notwendigen Aufheizvorgangs bedingt sind. Die Beschichtung des magnetischen Körpers mittels chemischer Gasphasenabscheidung kann insbesondere noch im gleichen Sinterofen erfolgen. In einem anderen nicht beanspruchten Ausführungsbeispiel erfolgt die Beschichtung mittels chemischer Gasphasenbeschichtung in einer weiteren Prozesskammer, insbesondere einer Fertigungsstraße. In jedem Fall kann der Herstellungsprozess beschleunigt werden kann, da die Beschichtung bereits während des Abkühlens des magnetischen Körpers erfolgt.

Vorzugsweise wird das Gas bzw. der Metalldampf zur chemischen Gasphasenabscheidung thermisch und/oder mittels Laserstrahlung und/oder mittels eines Plasmas aktiviert. Eine derartige Aktivierung des Gases ermöglicht eine Beschichtung bei Prozesstemperaturen, welche im Vergleich zu den beim physikalischen Aufdampfen vorherrschenden Prozesstemperaturen deutlich erniedrigt sind. Letztere betragen typischer Weise bis zu 1000°C, da das Aufdampfen normalerweise unter Unterdruck erfolgt. Zum Aufdampfen von Terbium werden sogar noch höhere Temperaturen benötigt, die bereits im Bereich der Sintertemperatur liegt. Abgesehen von dem erhöhten Energieeinsatz sind derartig hohe Temperaturen bei der Beschichtung auch deshalb nachteilig, da dann der Diffusionsprozess nicht mehr lediglich entlang von Korngrenzen erfolgt. Vielmehr erfolgt bereits eine Verteilung der Seltenerdelemente im Kornvolumen der Kristallite, so dass mit einem erhöhten Materialeinsatz gerechnet werden muss. Außerdem kann es bei hohen Prozesstemperaturen nahe der Sintertemperatur zu unerwünschten Veränderungen des Korngefüges, insbesondere zu nachteiligem Kornwachstum kommen.

Bei einer thermischen Aktivierung des Gases oder einer Aktivierung mittels Laserstrahlung und/oder mittels eines Plasmas kann die chemische Gasphasenabscheidung bei Prozesstemperaturen zwischen 300°C und 700°C erfolgen. Zudem kann die Reaktionsgeschwindigkeit in besonders vorteilhafter Weise beschleunigt werden. Die Aktivierung mittels Laserstrahlung ermöglicht insbesondere die gezielte Beeinflussung des Abscheidevorganges, so dass beispielsweise die schichtweise Abscheidung der Komponente auf gewünschte Teilbereiche der Oberfläche des magnetischen Körpers beschränkt wird.

Gemäß möglicher Ausführungsformen enthält das Gas Dysprosiumoxid, Terbiumoxid, DyCl₃, TbCl₃, DyBr₃, TbBr₃, Dy₂I₃, TbI₃, Dy₂F₃, DyS₃, TbF₃, Tb₂S₃, Dy (2, 2, 6, 6-Tetramethyl-3, 5-Heptandion)₃, Tb(2,2,6,6-Tetramethyl-3,5-Heptandion)3, Terbium(III)tris(2,2,6,6-tetramethyl-3,5-heptanedionat, Dysprosium(III)tris(2,2,6,6-tetramethyl-3, 5-heptanedionat, pi-Aren-Dy-Komplexe, pi-Aren-Tb-Komplexe, Tris(tert-butylcyclopentadienyl-dysprosium, Tris(tert-butylcyclopentadienyl-terbium, Bis(tert-butylcyclopentadienyl)-hydroxidodysprosium, Bis(tert-butylcyclopentadienyl)-hydroxidoterbium, aromatische Terbium--Carboxyl Verbindungen, Dysprosium-Carboxyl Verbindungen, Tris(cyclopentadienyl)terbium, Tris(tetramethylcylclopentadienyl)terbium, Terbiumdipivaloylmethanate, Dysprosium-dipivaloylmethanate, Tb(hfac)₃ Präkursoren, Dy(hfac)₃ Präkursoren, Tb(hfac)₃diglyme Präkursoren und/oder Dy(hfac)₃diglyme Präkursoren oder Mischungen von derartigen Verbindungen. Der Ausdruck "hfac" bezeichnet hier ein 1,1,1,5,5,5-Hexafluoroacetylacetonat.

Die Herstellung des Permanentmagneten erfolgt gemäß möglicher Ausführungsformen in dem Sinterofen derart unter Ausschluss von Sauerstoff, dass einer Oxidation der zu beschichtenden Oberfläche entgegen gewirkt ist. Dies ermöglicht die Herstellung des Permanentmagneten in einem sog. "near net-shape" Verfahren, ohne dass eine mechanische Behandlung der Oberfläche des magnetischen Körpers erfolgt.

Das Verfahren eignet sich besonders zur Herstellung von Neodym-Eisen-Bor Permanentmagneten, die mittels eines Sinterverfahrens aus einem metallhaltigen Pulver gebildet sind, welches entsprechend zumindest Neodym, Eisen und Bor enthält.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Für eine weitere Beschreibung der Erfindung wird auf die Ausführungsbeispiele der Zeichnungen verwiesen. Es zeigt in einer schematischen Prinzipskizze:
- FIG 1: ein Diagramm eines Temperaturverlaufs in einem Sinterofen, der zur Herstellung eines Permanentmagneten gemäß einem nicht erfindungsgemäßen Verfahren verwendet wird,
- FIG 2: ein schematisches Flussdiagramm eines erfindungsgemäßen Verfahrens zur Herstellung eines Permanentmagneten,
- FIG 3: ein Diagramm eines Temperaturverlaufs in einem Sinterofen, der in einem erfindungsgemäßen Verfahren verwendet wird.

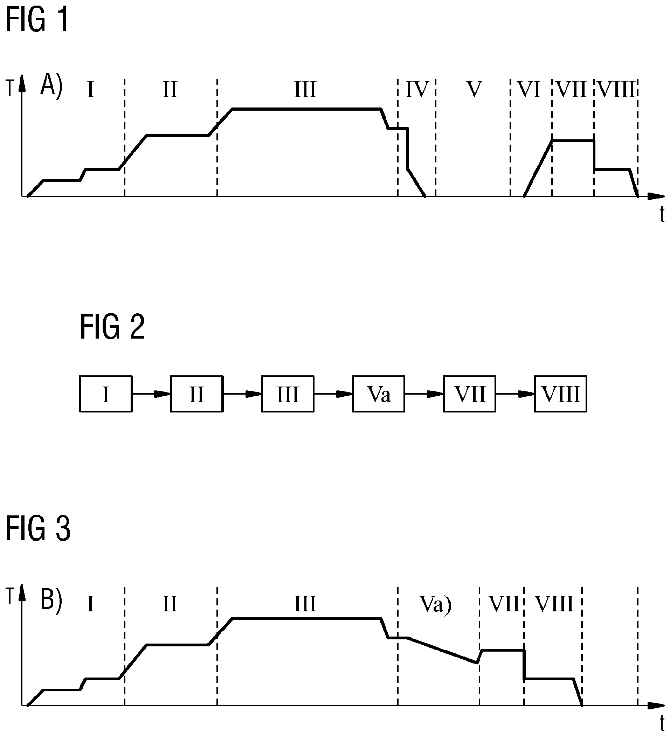

FIG 1 illustriert beispielhaft ein nicht erfindungsgemäßes Verfahren zur Herstellung eines Permanentmagneten anhand eines Temperaturverlaufs in einem zur Herstellung verwendeten Sinterofen. Im gezeigten Diagramm ist die im Sinterofen vorherrschende Temperatur T gegenüber der Zeit t aufgetragen.

Zunächst wird die Temperatur im Sinterofen in einem ersten Verfahrensschritt I stufenweise erhöht, um ein eingebrachtes metallhaltiges Pulver oder einen vorverfestigten Pressling von Additiven, insbesondere von Paraffin zu befreien.

Anschließend wird in einem zweiten Verfahrensschritt II die Temperatur weiter erhöht, um etwaig im metallhaltigen Pulver vorhandene Reststoffe auszugasen.

Im dritten Verfahrensschritt III wird das metallhaltige Pulver bis knapp unterhalb dessen Schmelztemperatur erhitzt, um aus dem metallhaltigen Pulver einen magnetischen Körper mittels Sintern zu bilden. Der Vorgang erfolgt unter Vakuum oder, alternativ dazu, unter einer Schutzgasatmosphäre. Gegebenenfalls können weitere Gase eingeleitet werden, um die chemische Zusammensetzung des zu bildenden magnetischen Körpers anzupassen.

Im darauf folgenden vierten Verfahrensschritt IV kühlt der gesinterte magnetische Körper ab, so dass dieser im Verfahrensschritt V aus dem Sinterofen entnommen werden kann. Bei der Entnahme kommt eine Oberfläche des magnetischen Körpers in Kontakt mit Sauerstoff, so dass diese oxidiert wird. Da die Oxidschicht eine Diffusion von Seltenerdelementen behindern würde, wird die Oxidschicht abgeschliffen, bevor der magnetische Körper mit einer Dysprosium und/oder Terbium enthaltenden Paste bedruckt wird.

Anschließend wird der bedruckte magnetische Körper zurück in den Sinterofen verbracht.

Im sechsten Verfahrensschritt VI wird die Temperatur im Sinterofen erhöht, bis eine Temperatur erreicht wird, die eine Diffusion des aufgebrachten Terbiums in das Material des magnetischen Körpers ermöglicht.

Während des siebten Verfahrensschrittes VII wird die Temperatur im Sinterofen auf diesem die Diffusion des Dysprosiums und/oder des Terbiums unterstützenden Temperaturniveaus konstant gehalten, bis der Diffusionsvorgang abgeschlossen ist.

Abschließend wird der magnetische Körper in einem achten Verfahrensschritt VIII für eine längere Zeitspanne auf einer geringfügig erniedrigten Temperatur gehalten, um einen Ausheilprozess in Gang zu setzten, bei dem die Konzentration von Gitterfehlern im magnetischen Körper reduziert wird.

Danach ist der Herstellungsprozess im Wesentlichen abgeschlossen und der so gebildete Permanentmagnet kann aus dem Sinterofen entnommen werden.

FIG 2 illustriert beispielhaft ein erfindungsgemäßes Verfahren zur Herstellung eines Permanentmagneten anhand eines schematischen Flussdiagramms.

Auch hier wird zunächst in einem ersten Verfahrensschritt I ein in einen Sinterofen eingebrachtes metallhaltiges Pulver oder ein aus vorverfestigtem Pulver bestehender Pressling von Additiven, insbesondere von Paraffin, durch Temperatureinwirkung befreit. Das verwendete metallhaltige Pulver ist in dem hier gezeigten Ausführungsbeispiel ein Pulver aus einer Neodym-Eisen-Bor umfassenden Legierung, es werden somit sogenannte Neodym-Eisen-Bor (NdFeB) Permanentmagnete mit hoher magnetischer Energiedichte hergestellt.

Im zweiten Verfahrensschritt II erfolgt ein Ausgasen von im metallhaltigen Pulver vorhandenen Reststoffen durch Temperatureinwirkung.

Im dritten Verfahrensschritt III wird der magnetische Körper analog zu dem bereits in FIG 1 gezeigten Verfahren aus dem metallhaltigen Pulver mittels Sintern erzeugt, mithin wird also das metallhaltige Pulver zur Bildung des gesinterten magnetischen Körpers auf eine geeignete Sintertemperatur erhitzt.

In einem weiteren Verfahrensschritt Va, welcher unmittelbar an den das Sintern betreffenden dritten Verfahrensschritt III anschließt, erfolgt ein schichtweises Abscheiden einer aus einem schweren Seltenerdelement bestehenden Komponente auf einer Oberfläche des magnetischen Körpers. Dazu verbleibt der magnetische Körper im Sinterofen, in welchem ein Gas, dass das schwere Seltenerdelement enthält, zur chemischen Gasphasenabscheidung eingeleitet wird, während der auf die Sintertemperatur erhitzte magnetische Körper abkühlt. An der heißen Oberfläche des magnetischen Körpers erfolgt eine thermisch induzierte Oberflächenreaktion, bei der die zumindest eine das Seltenerdelement aufweisende Komponente schichtweise abgeschieden wird.

In einem konkreten Ausführungsbeispiel enthält das eingebrachte Gas sowohl Dysprosium als auch Terbium, welches in Form von Dy₂F₃ bzw. TbF₃ in den Sinterofen eingebracht wird. Entsprechend enthalten die mittels der chemischen Gasphasenabscheidung erzeugten Schichten sowohl Terbium als auch Dysprosium.

Da die Beschichtung im weiteren Verfahrensschritt Va unter Ausschluss von Sauerstoff erfolgt, ist eine mechanische Oberflächenbehandlung zum Entfernen einer Oxidschicht nicht erforderlich. Der Diffusionsprozess kann somit im unmittelbar anschließenden siebten Verfahrensschritt VII erfolgen, wobei der magnetische Körper auf eine Temperatur erhitzt wird, die eine Diffusion des schweren Seltenerdelements entlang von vorhandenen Korngrenzen ermöglicht. Nachdem sich das Seltenerdelement im Oberflächen nahen Bereich der Korngrenzen hinreichend angereichert hat, wird die Temperatur im Sinterofen im achten Verfahrensschritt VIII geringfügig erniedrigt, um ein Ausheilen des Materials des magnetischen Körpers, bei dem die Konzentration von Gitterdefekten reduziert wird, zu bewirken.

Anschließend kann der fertiggestellte Permanentmagnet aus dem Sinterofen entnommen werden. Da bei dem in FIG 2 gezeigten Herstellungsverfahren keine mechanische Oberflächenbehandlung notwendig ist, handelt es sich hierbei um eine sogenannte "near net-shape" Herstellung von Permanentmagneten.

FIG 3 illustriert den Temperaturverlauf im Sinterofen, wenn dieser bei dem mit Bezug auf FIG 2 beschriebenen Verfahren zur Herstellung des Permanentmagneten Verwendung findet. FIG 3 zeigt schematisch den Verlauf der Temperatur T in Abhängigkeit der Zeit t.

Der Temperaturverlauf in dem ersten, zweiten und dritten Verfahrensschritt I, II, III ist nahezu identisch mit dem in FIG 1 gezeigten Temperaturverlauf. Diesbezüglich wird daher auf die bisherigen Ausführungen verwiesen.

Wie aus FIG 3 ersichtlich, erfolgt die chemische Gasphasenabscheidung zur Beschichtung der Oberfläche des magnetischen Körpers bei erhöhter Temperatur im weiteren Verfahrensschritt Va unmittelbar nach dem das Sintern betreffenden dritten Verfahrensschritt III. Die bei dem nicht erfindungsgemäßen Verfahren erforderlichen vierten und sechsten Verfahrensschritte IV, VI können entfallen, da bei dem in FIG 3 gezeigten Verfahren keine Entnahme des magnetischen Körpers aus dem Sinterofen zur Aufbringung der das Seltenerdelement enthaltende Beschichtung notwendig ist. Dies bedeutet eine Einsparung sowohl hinsichtlich des Energieverbrauchs, als auch eine vorteilhafte Verkürzung der zur Herstellung des Permanentmagnets erforderlichen Fertigungszeit.

Der Temperaturverlauf in dem die Diffusion des Seltenerdmetalls umfassenden siebten Verfahrensschritt VII und der Temperaturverlauf in dem die Ausheilung des Materials des magnetischen Körpers betreffende achte Verfahrensschritt VIII entspricht im Wesentlichen dem bereits in FIG 1 gezeigten Verlauf, so dass auf die diesbezüglichen Ausführungen verwiesen wird.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Herstellung eines Permanentmagneten, bei dem ein magnetischer Körper mittels Sintern aus einem metallhaltigen Pulver gebildet wird, wobei eine zumindest ein Seltenerdelement umfassende Komponente auf einer Oberfläche des magnetischen Körpers mittels chemischer Gasphasenabscheidung abgeschieden wird und der beschichtete magnetische Körper anschließend einer eine Diffusion der auf der Oberfläche des magnetischen Körpers abgeschiedenen Komponente entlang von Korngrenzen unterstützenden thermischen Behandlung unterzogen wird, **dadurch gekennzeichnet, dass** ein das zumindest eine Seltenerdelement enthaltendes Gas in einen Sinterofen zur chemischen Gasphasenabscheidung eingeleitet wird und die das Sintern, die chemische Gasphasenabscheidung und die Diffusion unterstützende thermische Behandlung betreffenden Verfahrensschritte (III, Va, VII, VIII) im gleichen Sinterofen erfolgen.

2. Verfahren nach einem der vorherigen Ansprüche, **dadurch gekennzeichnet, dass** das Seltenerdelement ein schweres Seltenerdelement ist.

3. Verfahren nach Anspruch 2, **dadurch gekenn**- **zeichnet**, dass das schwere Seltenerdelement Dysprosium und/oder Terbium ist.

4. Verfahren nach einem der vorherigen Ansprüche, **dadurch gekennzeichnet, dass** die das zumindest eine Seltenerdelement umfassende Komponente auf der Oberfläche des magnetischen Körpers während eines dem Sintern unmittelbar anschließenden Abkühlvorgangs des magnetischen Körpers abgeschieden wird.

5. Verfahren nach einem der vorhergehenden Ansprüche, **dadurch gekennzeichnet, dass** das Gas zur chemischen Gasphasenabscheidung thermisch und/oder mittels Laserstrahlung und/oder mittels eines Plasmas aktiviert wird.

6. Verfahren nach Anspruch 5, **dadurch gekenn- zeichnet,** dass das Gas Dysprosiumoxid, Terbiumoxid, DyCl₃, TbCl₃, DyBr₃, TbBr₃, Dy₂I₃, TbI₃, Dy₂F₃, DyS₃, TbF₃, Tb₂S₃, Dy(2,2,6,6-Tetramethyl-3,5-Heptandion)₃, Tb(2,2,6,6-Tetramethyl-3,5-Heptandion)₃, Terbium(III)tris(2,2,6,6-tetramethyl-3,5-heptanedionat, Dysprosium(III)tris(2,2,6,6-tetramethyl-3, 5-heptanedionat, pi-Aren-Dy-Komplexe, pi-Aren-Tb-Komplexe, Tris(tert-butylcyclopentadienyl-dysprosium, Tris(tert-butylcyclopentadienyl-terbium, Bis(tert-butylcyclopentadienyl)-hydroxidodysprosium, Bis(tert-butylcyclopentadienyl)-hydroxidoterbium, aromatische Terbium--Carboxyl Verbindungen, Dysprosium-Carboxyl Verbindungen, Tris(cyclopentadienyl)terbium, Tris(tetramethylcylclopentadienyl)terbium, Terbiumdipivaloylmethanate, Dysprosium-dipivaloylmethanate, Tb(hfac)₃ Präkursoren, Dy(hfac)₃ Präkursoren, Tb(hfac)₃diglyme Präkursoren und/oder Dy(hfac)₃diglyme Präkursoren enthält, wobei mit hfac ein 1,1,1,5,5,5-Hexafluoroacetylacetonat bezeichnet ist.

7. Verfahren nach einem der vorhergehenden Ansprüche, **da- durch gekennzeichnet**, dass die Herstellung des Permanentmagneten ohne eine mechanische Behandlung der Oberfläche des magnetischen Körpers erfolgt.

8. Verfahren nach einem der vorhergehenden Ansprüche, **dadurch gekennzeichnet, dass** das metallhaltige Pulver zumindest Neodym, Eisen und Bor enthält.

## Claims

1. Method for manufacturing a permanent magnet, in which a magnetic body is formed from a metalliferous powder by means of sintering, wherein a component comprising at least one rare earth element is deposited on a surface of the magnetic body by means of chemical gas phase deposition and the coated magnetic body is then subject to a thermal treatment supporting a diffusion of the component deposited on the surface of the magnetic body along grain boundaries, **characterised in that** a gas containing the at least one rare earth element is introduced into a sintering furnace for the chemical gas phase deposition and the method steps (III, Va, VII, VIII) relating to the sintering, the chemical gas phase deposition and the thermal treatment supporting diffusion take place in the same sintering furnace.

2. Method according to one of the preceding claims, **characterised in that** the rare earth element is a heavy rare earth element.

3. Method according to claim 2, **characterised in that** the heavy rare earth element is dysprosium and/or terbium.

4. Method according to one of the preceding claims, **characterised in that** the component comprising the at least one rare earth element is deposited on the surface of the magnetic body during a cooling process of the magnetic body immediately subsequent to the sintering.

5. Method according to one of the preceding claims, **characterised in that** the gas for the chemical gas phase deposition is activated thermally and/or by means of laser radiation and/or by means of a plasma.

6. Method according to claim 5, **characterised in that** the gas contains dysprosium oxide, terbium oxide, DyCl₃, TbCl₃, DyBr₃, TbBr₃, Dy₂I₃, TbI₃, Dy₂F₃, DyS₃, TbF₃, Tb₂S₃, Dy(2,2,6,6-tetramethyl-3,5-heptanedione)₃, Tb(2,2,6,6-tetramethyl-3,5-heptanedione)₃, terbium(III)tris(2,2,6,6-tetramethyl-3,5-heptanedionate, dysprosium(III)tris(2,2,6,6-tetramethyl-3,5-heptanedionate, pi-arene-Dy complexes, pi-arene-Tb complexes, tris(tert-butylcyclopentadienyl-dysprosium, tris(tert-butylcyclopentadienyl-terbium, bis(tert-butylcyclopentadienyl)-hydroxidodysprosium, bis(tert-butylcyclopentadienyl)-hydroxidoterbium, aromatic terbium-carboxyl compounds, dysprosium-carboxyl compounds, tris(cyclopentadienyl)terbium, tris(tetramethylcylclopentadienyl)terbium, terbium dipivaloylmethanates, dysprosium dipivaloylmethanates, Tb(hfac)₃ precursors, Dy(hfac)₃ precursors, Tb(hfac)₃diglyme precursors and/or Dy(hfac)₃diglyme precursors, wherein hfac designates a 1,1,1,5,5,5-hexafluoroacetylacetonate.

7. Method according to one of the preceding claims, **characterised in that** the manufacture of the permanent magnet takes place without any mechanical treatment of the surface of the magnetic body.

8. Method according to one of the preceding claims, **characterised in that** the metalliferous powder contains at least neodymium, iron and boron.

## Revendications

1. Procédé de production d'un aimant permanent, dans lequel on forme un corps magnétique au moyen d'un frittage à partir d'une poudre contenant du métal, dans lequel on dépose, au moyen d'un dépôt chimique en phase vapeur, au moins un constituant comprenant un élément de terre rare sur une surface du corps magnétique et on soumet le corps magnétique revêtu ensuite à un traitement thermique favorisant une diffusion du constituant déposé à la surface du corps magnétique le long de joints de grain, **caractérisé en ce que** l'on introduit, pour le dépôt chimique en phase gazeuse, dans un four de frittage, un gaz contenant le au moins un élément de terre rare et on effectue, dans le même four de frittage, les stades (III, Va, VII, VIII) de procédé concernant le frittage, le dépôt chimique en phase gazeuse et le traitement thermique favorisant la diffusion.

2. Procédé suivant l'une des revendications précédentes, **caractérisé en ce que** l'élément de terre rare est un élément de terre rare lourd.

3. Procédé suivant la revendication 2, **caractérisé en ce que** l'élément de terre rare lourd est le dysprosium et/ou le terbium.

4. Procédé suivant l'une des revendications précédentes, **caractérisé en ce que** l'on dépose le constituant comprenant au moins un élément de terre rare à la surface du corps magnétique pendant une opération de refroidissement, venant immédiatement après le frittage, du corps magnétique.

5. Procédé suivant l'une des revendications précédentes, **caractérisé en ce que** l'on active thermiquement et/ou au moyen d'un faisceau laser et/ou au moyen d'un plasma le gaz pour le dépôt chimique en phase vapeur.

6. Procédé suivant la revendication 5, **caractérisé en ce que** le gaz contient de l'oxyde de dysprosium, de l'oxyde de terbium, DyCl₃, TbCl₃, DyBr₃, TbBr₃, Dy₂I₃, TbI₃, Dy₂F₃, DyS₃, TbF₃, Tb₂S₃, de la Dy(2,2,6,6-tétraméthyl-3,5-heptanedione)₃, de la Tb(2,2,6,6-tétraméthyl-3,5-heptanedione)₃, du tris(2,2,6,6-tétraméthyl-3,5-heptanedionate) de terbium (III), du tris(2,2,6,6-tétraméthyl-3,5-heptanedionate) de dysprosium (III), des complexes pi-arène-Dy, des complexes pi-arène-Tb, du tris(tert-butylcyclopentadiènyl-disprosium), du tris(tert-butylcyclo-pentadiènyl-terbium), du bis(tert-butylcyclopenta-diènyl-hydroxyde de dysprosium, du bis(tert-butylcyclopenta-diènyl-hydroxyde de terbium, des composés terbium-carboxyle, des composés dysprosium-carboxyle aromatiques, du tris (cyclopentadiényl) terbium, du tris(tétraméthylcyclopentadiène) terbium, du dipivaloylméthanate de terbium, du dipivaloylméthanate de dysprosium, des précurseurs de Tb(hfac)₃, des précurseurs de Dy(hfac)₃, des précurseurs de Tb(hfac)₃diglyme et/ou des précurseurs de Dy(hfac)₃diglyme, hfac désignant un acétonate de 1,1,1,5,5,5,-héxafluoroacétyle.

7. Procédé suivant l'une des revendications précédentes, **caractérisé en ce que** la production de l'aimant permanent s'effectue sans un traitement mécanique de la surface du corps magnétique.

8. Procédé suivant l'une des revendications précédentes, **caractérisé en ce que** la poudre contenant du métal contient au moins du néodyme, du fer et du bore.
